(19) Europäisches Patentamt
European Patent Office
Office européen des brevets

(11) **EP 0 984 160 B1**

(12) **EUROPÄISCHE PATENTSCHRIFT**

(45) Veröffentlichungstag und Bekanntmachung des Hinweises auf die Patenterteilung:
**26.05.2004 Patentblatt 2004/22**

(51) Int Cl.⁷: **F02P 3/12**, F02P 3/02

(21) Anmeldenummer: **99113093.1**

(22) Anmeldetag: **06.07.1999**

(54) **Spannungstransformator**

Voltage transformer

Transformateur de tension

(84) Benannte Vertragsstaaten:
**DE ES FR GB IT**

(30) Priorität: **31.07.1998 DE 19834673**

(43) Veröffentlichungstag der Anmeldung:
**08.03.2000 Patentblatt 2000/10**

(73) Patentinhaber: **SIEMENS AKTIENGESELLSCHAFT 80333 München (DE)**

(72) Erfinder:
• **Mock, Randolf, Dr.**
  **81739 München (DE)**
• **Kappel, Andreas, Dr.**
  **85649 Brunnthal (DE)**

(56) Entgegenhaltungen:
**EP-A- 0 748 935      DE-A- 4 131 553
JP-A- 60 190 667**

## Beschreibung

Die Erfindung betrifft eine Vorrichtung und ein Verfahren zur Spannungstransformation sowie eine Verwendung einer solchen Vorrichtung.

Im Hinblick auf einen minimalen Schadstoffausstoß eines Motors ist eine möglichst gute Verbrennung des in den Motor eingebrachten Benzin-Luft-Gemisches notwendig. Dazu wird zunehmend die Forderung nach einer Zündspannung einer Zündkerze zur optimalen Zündung des Gemisches im Bereich von 40 kV gestellt.

Bisher ist eine Zündanlage auf der Basis einer Magnetspule realisiert. Eine Zündspannung im 40-kV-Bereich ist aber mit einer solchen herkömmlichen Spule nur bei einem inakzeptabel großen Bauvolumen und einem hohen Kostenaufwand erreichbar. Außerdem ist wegen der relativ hohen Induktivität eine Mehrfachzündung nicht realisierbar.

Die Aufgabe der vorliegenden Erfindung ist es, einen Spannungstransformator mit vergleichsweise kompaktem Volumen und hoher Leistungsdichte bereitzustellen.

Diese Aufgabe wird durch die Merkmale der Patentansprüche 1, bzw.10 gelöst.

Die Idee der Erfindung besteht darin, ein jeweils in Form eines Vielschicht-Piezoelementes vorliegendes Primär- und Sekundärteil gemeinsam in ein Joch einzuspannen, und durch eine Längenänderung des Primärteils mittels des Jochs eine Längenänderung des Sekundärteils hervorzurufen, wodurch am Sekundärteil eine elektrische Spannung erzeugt wird. Aufgrund des piezoelektrischen Wirkprinzips ergibt sich ein Verhältnis in der Größe des das Primärteil ansteuernden elektrischen Signals zu der Größe des am Sekundärteil abgegriffenen elektrischen Signals.

Dieser Spannungstransformator stellt bei vergleichsweise kompaktem Volumen eine hohe Leistungsdichte bereit.

Auch ist es vorteilhafterweise möglich, eine hohe so Ansprechgeschwindigkeit zu erreichen, daß im 40-kV-Bereich eine Mehrfachzündung einer Zündkerze möglich ist:

Weiterhin ergibt sich der Vorteil, daß durch die Anordnung kein signifikantes Magnetfeld erzeugt wird.

Zur vereinfachten Herstellung ist es vorteilhaft, wenn jeweils ein Primär- und Sekundärteil verwendet wird.

Beispielsweise zur besseren Ansteuerung des Vielschicht-Piezoelementes ist es vorteilhaft, wenn jede piezoelektrische Einzelschicht des Primärteils einzeln kontaktiert und somit einzeln ansteuerbar ist. Eine analoge Überlegung gilt für das Sekundärteils zur optimierten Signalabgabe.

Weiterhin ist es vorteilhaft, wenn die Schichtdicke jeder piezoelektrischen Einzelschicht jeweils eines zusammenhängenden Primär- oder Sekundärteil gleich ist. Dadurch wird erstens der Herstellungsprozeß vereinfacht, und zweitens gestaltet sich beispielsweise die Handhabung der Signaleingabe bzw. -ausgabe einfacher.

Das Primär- und das Sekundärteil können beispielsweise übereinander, nebeneinander oder auch ineinander angeordnet sein.

In den folgenden Ausführungsbeispielen wird der Spannungstransformator schematisch dargestellt.

Figur 1 zeigt das Funktionsprinzip des Spannungstransformators,

Figur 2a - Figur 2c zeigen unterschiedliche Ausführungsformen des Spannungstransformators.

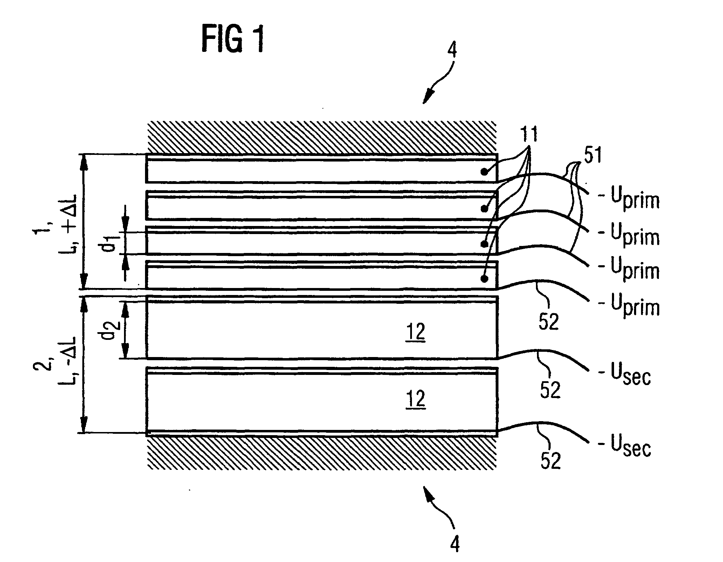

In Figur 1 ist als Schnittdarstellung in Seitenansicht ein Spannungstransformator aufgezeichnet. Zur verbesserten Darstellung sind einzelne Teile des Spannungstransformators voneinander abgehoben.

Ein Primärteil 1 ist aus mehreren übereinander angebrachten piezoelektrischen Einzelschichten 11 mit einer jeweiligen Schichtdicke d1 zusammengesetzt. Die piezoelektrischen Einzelschichten 11 sind jeweils durch eine Kontaktelektrode 51 voneinander getrennt. Das Primärteil 1 ist auf einem Sekundärteil 2 angebracht. Das Sekundärteil 2 ist entsprechend dem Primärteil 1 aus einem Schichtstapel mit piezoelektrischen Einzelschichten 12 der Einzelschichtdicke d2 zusammengesetzt. Auch die piezoelektrischen Einzelschichten 12 des Sekundärteils 2 sind jeweils durch eine Kontaktelektrode 52 voneinander getrennt. Aus der Einzelschichtdicke d1 bzw. d2 ergibt sich additiv die jeweilige Länge des Primärteils 1 bzw. des Sekundärteils 2.

Das Primärteil 1 und das Sekundärteil 2 sind an ihrer freien Stirnfläche, d. h. der freien Oberfläche in axialer Richtung, in einem Joch 4 eingespannt.

In diesem Ausführungsbeispiel entspricht die Länge des Primärteils 1 der Länge des Sekundärteils 2, die hier mit L bezeichnet wird. An der jeweiligen Kontaktelektrode 51 einer piezoelektrische Einzelschicht 11 des Primärteils 1 liegt ein primärseitiges Spannungssignal Uprim an, über das die auf dem piezoelektrischen Wirkprinzip beruhende Dehnung der piezoelektrischen Einzelschicht 11 gesteuert wird. Analog wird am Sekundärteil über die entsprechenden Kontaktelektroden 52 eine durch eine Dehnung einer piezoelektrischen Einzelschicht 12 des Sekundärteils 2 erzeugte Spannung Usec abgegriffen.

Zur Spannungstransformation werden die piezoelektrischen Einzelschichten 11 des Primärteils 1 mit einem Spannungssignal Uprim angesteuert. Dadurch dehnt sich der Primärteil 1 um den Betrag ΔL aus. Im gleichen Maße wird der Sekundärteil um einen Betrag ΔL gestaucht. Für das elektrische Feld, welches durch eine Stauchung in einem Piezoelement aufgebaut wird, gilt:

$$E = const. \, \frac{\Delta L}{L}.$$

Weil das Verhältnis ΔL/L für das Primärteil 1 und das Sekundärteil 2 wegen der gleichen Bauhöhe L gleich ist und sich die elektrische Spannung U ergibt zu: U = E*d, folgt:

Eprim = Esec
Uprim = E $d_1$
Usec = E $d_2$

Bei paralleler Verschaltung der piezoelektrischen Einzelschichten 11,12 des Primärteils 1 bzw. des Sekundärteils 2 ist das Übersetzungsverhältnis definiert durch das Verhältnis der Schichtdicke d1 des Primärteils 1 und der Schichtdicke d2 des Sekundärteils 2 entsprechend

Usec/Uprim = d2/d1.

Eine unterschiedliche Baulänge L bzw. Stauchung ist vom Fachmann in einfacher Weise in die Berechnung der Spannungstransformation einbringbar.

Ein entsprechendes Ergebnis kann auch durch eine geeignete Verschaltung von Schichten gleicher Dicke des Primärteils 1 und Sekundärteils 2, also bei d1 = d2, erreicht werden, wenn die piezoelektrischen Einzelschichten 11 des Primärteils 11 parallel und die piezoelektrischen Einzelschichten 12 des Sekundärteils 2 in Serie geschaltet werden. Zur Erlangung eines gewünschten Transformationsverhältnisses zwischen Uprim und Usec ist auch eine beliebige Kombination einer Parallel- und Serienverschaltung möglich. Auch kann entweder das Primärteil 1 oder das Sekundärteil 2 aus einer einzigen piezoelektrischen Einzelschicht 11, 12 bestehen. Es vorteilhaft, wenn auch fertigungstechnisch aufwendig, wenn jede piezoelektrische Einzelschicht 11, 12 separat elektrisch ansteuerbar ist. Es ist günstig, wenn die piezoelektrischen Einzelschichten 11, 12 aus einem Material bestehen.

Es ist zum Einsatz bei einer hohen Arbeitstemperatur vorteilhaft, wenn die piezoelektrischen Einzelschichten 11, 12 aus einem keramischen bzw. keramikähnlichen Material bestehen. Beim Einsatz solcher piezoelektrischen Einzelschichten 11, 12 mit einer entsprechend hohen Curie-Temperatur von beispielsweise 400°C ist ein Einsatz des Spannungstransformators sogar in unmittelbarer Nähe einer Zündkerze möglich.

Es ist vorteilhaft, wenn die Schichtdicke (d1,d2) einer piezoelektrischen Einzelschicht 20-400 µm beträgt. Es ist weiterhin vorteilhaft, wenn 25-250 Einzelschichten (11,12) pro Primärteil (1) bzw. Sekundärteil (2) vorhanden sind.

Es ist weiterhin günstig, wenn das Eingangssignal (Uprim) als Wechselspannung mit einer Frequenz zwischen 5 kHz und 50 kHz vorliegt.

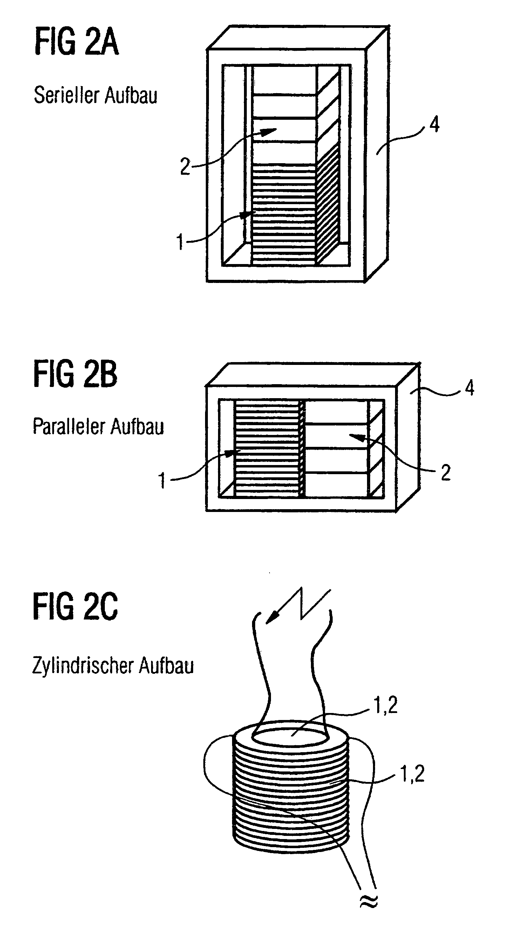

In Figur 2a ist ein Spannungstransformator aufgezeichnet, bei dem Primärteil 1 und Sekundärteil 2 hintereinander angeordnet in einem Joch 4 eingespannt sind. Zur besseren Übersichtlichkeit sind die elektrischen Kontaktelemente und Anschlüsse nicht eingezeichnet.

An das Primärteil 1 wird ein Eingangssignal, beispielsweise ein Niederspannungssignal Uprim angelegt, wodurch es sich um den Betrag ΔL ausdehnt. Wegen der Dehnungsbehinderung durch das feste Joch 4 wird das Sekundärteil 2 um den gleichen Betrag gestaucht, und es ergibt sich eine Spannungstransformation des Eingangssignals Uprim zum Ausgangssignal Usec. Das Primärteil 1 und das Sekundärteil 2 besitzen vorteilhafterweise die gleiche Baulänge L.

Der Effekt einer unterschiedlichen Länge ist eine Druckvorspannung der piezoelektrischen Einzelschichten 11, 12 im Joch 4. Dies ist zur Vermeidung schädlicher Zugspannungen, insbesondere an einem keramischen oder keramikähnlichen Material, vorteilhaft.

In Figur 2b sind das Primärteil 1 und das Sekundärteil 2 nebeneinander angeordnet in einem festen Joch eingespannt. Durch Anlegen eines Eingangssignals Uprim an das Primärteil 1 wird dieses ausgedehnt und dehnt gleichzeitig das Joch 4. Aufgrund der Dehnung des Jochs 4 wird auch das Sekundärteil 2 in der gleichen Richtung wie das Primärteil 1 ausgedehnt. Es ergibt sich wiederum eine Spannungstransformation zwischen Uprim und Usec. In diesem Ausführungsbeispiel ist eine Druckvorspannung der piezoelektrischen Einzelschichten 11, 12 besonders vorteilhaft, da eine keramikähnliche Schicht sehr empfindlich auf Zugspannungen reagiert.

In Figur 2c ist eine zu Figur 2b analoge Anordnung aufgetragen, bei der Primärteil 1 und Sekundärteil 2 ineinander angeordnet im Joch 4 fest eingespannt sind. Zur besseren Darstellung dieser Anordnung ist das Joch 4 nicht dargestellt.

Auch hier wird durch eine Ansteuerung des Primärteils 1 das Joch 4 so gedehnt, daß auch das Sekundärteil 2 in der gleichen Richtung wie das Primärteil 1 ausgedehnt wird.

Ein wichtiger Vorteil des piezoelektrischen Spannungstransformators ist es, daß er weitestgehend linear arbeitet. Es heißt, daß - anders als beim induktiv arbeitenden Spulentrafo

- die Ausgangsspannung Usec direkt proportional zur Eingangsspannung Uprim ist.

Darüber hinaus weist der piezoelektrische Spannungstransformator einen sehr breiten Übergangsbereich auf, in dem er diese lineare Arbeitsweise beibehält. Er arbeitet daher - im Unterschied zum klassischen Transformator - auch wie ein Spannungsverstärker. Dadurch ist zum Beispiel die Möglichkeit gegeben, Form und Anzahl der Zündimpulse einer Zündkerze in weiten Grenzen den Erfordernissen der Gemischzündung eines Kraftstoffmotors anzupassen.

Aufgrund der vergleichsweise freien Wahl der Anordnung des Primärteils 1 und des Sekundärteils 2 im Joch 4 wird zudem eine vergleichsweise kompakte Bauweise ermöglicht.

Der piezoelektrische Spannungstransformator ist selbstverständlich nicht auf eine Anwendung im Automobilbereich beschränkt, sondern kann allgemein zur Spannungstransformation , z. B. anstatt eines elektromagnetischen Transformators, verwendet werden. Bevorzugt wird der piezoelektrische Spannungstransformator dabei in einer rauhen Umgebung eingesetzt. So ist bei einer hohen Curie-Temperatur des piezoelektrischen Materials der Einsatz bei einer hohen Außentemperatur möglich, bei der ein elektromagnetischen Transformators nur mit hohem Aufwand betreibbar ist. So ist ein Einsatz in einem Ölbrenner denkbar.
Auch ist eine Anwendung vorteilhaft in einer magnetisch stark belasteten Umgebung, z. B. in der Nähe eines Computer-Tomographen oder in der NMR-Spektroskopie.

**Patentansprüche**

1. Spannungstransformator, aufweisend

   - ein Primärteil (1) in Form eines aus einer alternierenden Folge von mindestens zwei piezoelektrischen Einzelschichten (11) und Kontaktelektroden (51) aufgebauten Vielschicht-Piezoelementes,
   - ein Sekundärteil (2) in Form eines aus einer alternierenden Folge von mindestens zwei weiteren piezoelektrischen Einzelschichten (12) und weiteren Kontaktelektroden (52) aufgebauten Vielschicht-Piezoelementes,
   - ein Joch (4), in das das Primärteil (1) und das Sekundärteil (2) eingespannt sind,

   **dadurch gekennzeichnet, daß** das Primärteil (1) und das Sekundärteil (2) nebeneinander oder ineinander im Joch (4) eingespannt sind.

2. Vorrichtung nach einem der vorhergehenden Ansprüche, bei der das Primärteil (1) und das Sekundärteil (2) die gleiche Länge (L) besitzen.

3. Vorrichtung nach einem der Ansprüche 1 bis 2, bei der eine Dicke (d1) der piezoelektrischen Einzelschicht (11) des Primärteils (1) von einer Dicke (d2) der weiteren piezoelektrischen Einzelschicht (12) des Sekundärteils (2) verschieden ist, und die piezoelektrischen Einzelschichten (11,12) elektrisch parallel geschaltet sind.

4. Vorrichtung nach einem der Ansprüche 1 bis 2, bei der eine Dicke (d1) der piezoelektrischen Einzelschicht (11) des Primärteils (1) und eine Dicke (d2) der piezoelektrischen Einzelschicht (12) des Sekundärteils (2) gleich ist, und die piezoelektrischen Einzelschichten (11,12) elektrisch seriell geschaltet sind.

5. Vorrichtung nach einem vorhergehenden Ansprüche, bei der die Schichtdicke (d1,d2) der piezoelektrischen Einzelschichten (11,12) 20-400 μm beträgt.

6. Vorrichtung nach einem vorhergehenden Ansprüche, bei der 25-250 Einzelschichten (11,12) pro Primärteil (1) bzw. Sekundärteil (2) vorhanden sind.

7. Vorrichtung nach einem vorhergehenden Ansprüche, bei der die piezoelektrischen Einzelschichten (11,12) keramisch bzw. keramikähnlich sind.

8. Vorrichtung nach einem vorhergehenden Ansprüche zum Betrieb einer Zündkerze.

9. Vorrichtung nach Anspruch 8, bei der die Curie-Temperatur der Einzelschichten (11,12) mindestens 400 °C beträgt.

10. Verfahren zur Spannungstransformation, bei dem ein Primärteil (1) und ein Sekundärteil (2), die jeweils in Form mindestens eines Vielschicht-Piezoelementes vorliegen, nebeneinander oder ineinander sowie, in einem Joch (4) druckvorgespannt sind, so daß während eines Betätigungsvorgangs

    - über ein elektrisches Eingangssignal (Uprim) an das Primärteil (1) angelegt wird, so daß das Primärteil (1) expandiert, wodurch auch das Joch (4) expandiert,
    - durch die Expansion des Jochs (4) das Sekundärteil (2) maximal um die gleiche Länge expandiert, so daß ein am Sekundärteil (2) spannungstransformiertes elektrisches Ausgangsignal (Usec) abgegriffen wird,
    zur Beendigung eines Betätigungsvorgangs
    - das elektrische Eingangssignal (Uprim) ausgeschaltet wird, so daß das Primärteil (1) auf seine ursprüngliche Länge kontrahiert wird, wodurch auch das Joch (4) und das Sekundärteil (2) kontrahiert werden.

11. Verfahren nach Anspruch 10, bei dem
    die Länge (L) des Primärteils (1) und des Sekundärteils (2) gleich ist,
    so daß das Verhältnis des jeweils an einer Einzelschicht (11) des Primärteils (1) angelegten Eingangsignals (Uprim) zum jeweils an einer Einzelschicht (12) des Sekundärteils (2) abgegriffenen Ausgangsignals (Usec) im wesentlichen der Gleichung

$$\frac{U \sec}{U prim} = \frac{d2}{d1}$$

proportional ist.

## Claims

1. Voltage transformer, having

   - a primary component (1) in the form of a multi-layer piezo-element composed of an alternating series of at least two piezoelectric individual layers (11) and contact electrodes (51),
   - a secondary component (2) in the form of a multi-layer piezo-element composed of an alternating series of at least two further piezoelectric individual layers (12) and further contact electrodes (52),
   - a yoke (4) into which the primary component (1) and the secondary component (2) are clamped,

   **characterized in that**,
   the primary component (1) and the secondary component (2) are clamped next to each other or inside each other in the yoke (4).

2. A device according to one of the preceding claims, in which the primary component (1) and the secondary component (2) are of the same length (L).

3. A device according to one of Claims 1 to 2, in which the thickness (d1) of the piezoelectric individual layer (11) of the primary component (1) is different from the thickness (d2) of the additional piezoelectric individual layer (12) of the secondary component (2), and the piezoelectric individual layers (11,12) are electrically connected in parallel.

4. A device according to one of Claims 1 to 2, in which the thickness (d1) of the piezoelectric individual layer (11) of the primary component (1) is equivalent to the thickness (d2) of the piezoelectric individual layer (12) of the secondary component (2), and the piezoelectric individual layers (11,12) are electrically connected in series.

5. A device according to one of the preceding claims, in which the layer thickness (d1,d2) of the piezoelectric individual layers (11,12) is 20-400 µm.

6. A device according to one of the preceding claims, in which there are 25-250 individual layers (11,12) per primary component (1) or secondary component (2).

7. A device according to one of the preceding claims, in which the piezoelectric individual layers (11,12) are ceramic or ceramic-like.

8. A device according to one of the preceding claims, for operation of a spark plug.

9. A device according to Claim 8, in which the Curie temperature of the individual layers (11,12) is at least 400 °C.

10. Method for voltage transformation, in which a primary component (1) and a secondary component (2), each in the form of at least one multi-layer piezo-element, are precompressed next to each other or inside each other and in a yoke so that during an operating procedure

    - voltage is applied to the primary component (1) via an electric input signal (Uprim), so that the primary component (1) expands, as a result of which the yoke (4) also expands,
    - through the expansion of the yoke (4) the secondary component (2) expands by a maximum of the same length, so that a voltage-transformed electrical output signal (Usec) at the secondary component (2) is tapped,
    to terminate an operating procedure
    - the electrical input signal (Uprim) is switched off so that the primary component (1) is contracted back to its original length, as a result of which the yoke (4) and the secondary component (2) are also contracted.

11. Method according to Claim 10, in which the length (L) of the primary component (1) and of the secondary component (2) is the same,
    so that the ratio between each input signal (Uprim) applied to an individual layer (11) of the primary component (1) and the tapped output signal (Usec) on an individual layer (12) of a secondary component (2) in each case is essentially proportional to the equation

$$\frac{U \sec}{U prim} = \frac{d2}{d1}$$

## Revendications

1. Transformateur de tension, comprenant:

   - un élément primaire (1) sous forme d'un élément piézoélectrique multicouches, constitué d'une série alternée d'au moins deux couches piézoélectriques individuelles (11) et d'électrodes de contact (51),
   - un élément secondaire (2) sous forme d'un élément piézoélectrique multicouches, constitué d'une série alternée d'au moins deux couches piézoélectriques individuelles (12) supplémentaires et d'électrodes de contact (52) supplémentaires,
- un joug, dans lequel l'élément primaire (1) et l'élément secondaire (2) sont encastrés,

**caractérisé en ce que**
l'élément primaire (1) et l'élément secondaire (2) sont encastrés l'un à côté de l'autre ou l'un dans l'autre dans le joug (4).

2. Dispositif selon l'une quelconque des revendications précédentes, dans lequel l'élément primaire (1) et l'élément secondaire (2) présentent la même longueur (L).

3. Dispositif selon l'une quelconque des revendications 1 à 2, dans lequel une épaisseur (d1) de la couche piézoélectrique individuelle (11) de l'élément primaire (1) et une épaisseur (d2) de la couche piézoélectrique individuelle (12) de l'élément secondaire (2) sont différentes et les couches piézoélectriques individuelles (11, 12) sont électriquement couplées en parallèle.

4. Dispositif selon l'une quelconque des revendications 1 à 2, dans lequel une épaisseur (d1) de la couche piézoélectrique individuelle (11) de l'élément primaire (1) et une épaisseur (d2) de la couche piézoélectrique individuelle (12) de l'élément secondaire (2) sont égales et les couches piézoélectriques individuelles (11,12) sont électriquement couplées en série.

5. Dispositif selon l'une quelconque des revendications précédentes, dans lequel l'épaisseur (d1, d2) des couches piézoélectriques individuelles (11, 12) est de 20 à 400 μm.

6. Dispositif selon l'une quelconque des revendications précédentes, dans lequel l'élément primaire (1) resp. l'élément secondaire (2) sont constitués de 25 à 250 couches individuelles (11, 12).

7. Dispositif selon l'une quelconque des revendications précédentes, dans lequel les couches piézoélectriques individuelles (11, 12) sont céramiques resp. analogues à la céramique.

8. Dispositif selon l'une quelconque des revendications précédentes, pour faire fonctionner une bougie d'allumage.

9. Dispositif selon la revendication 8, dans lequel le point de Curie des couches individuelles (11, 12) est de 400°C au moins.

10. Procédé pour la transformation de tension, dans lequel un élément primaire (1) et un élément secondaire (2) qui sont respectivement présents sous la forme d'au moins un élément piézoélectrique multicouches sont précontraints par compression l'un à côté de l'autre ou l'un dans l'autre dans un joug (4), pour que pendant un processus d'utilisation

- un signal d'entrée électrique (Uprim) soit appliqué à l'élément primaire (1), pour que l'élément primaire (1) soit soumis à une expansion, ayant pour effet de soumettre également le joug à une expansion,
- l'expansion du joug (4) ait pour effet de soumettre également l'élément secondaire (2) à une expansion correspondant au maximum à une longueur identique, pour qu'un signal de sortie électrique (Usec),dont la tension est transformée à l'élément secondaire (2) soit prélevée, et pour l'achèvement d'un processus d'utilisation
- le signal d'entrée électrique (Uprim) soit déconnecté, pour que l'élément primaire (1) soit contracté à sa longueur initiale, soumettant également le joug (4) et l'élément secondaire (2) à une contraction.

11. Procédé selon la revendication 10, dans lequel la longueur (L) de l'élément primaire (1) et de l'élément secondaire (2) est égale, pour que le rapport du signal d'entrée (Uprim) respectivement appliqué à une couche individuelle (11) de l'élément primaire (1) au signal de sortie (Usec) respectivement prélevé sur un couche individuelle (12) de l'élément secondaire (2) soit sensiblement proportionnel à l'équation

$$\frac{Usec}{Uprim} = \frac{d2}{d1}.$$

# FIG 1

# FIG 2A

Serieller Aufbau

# FIG 2B

Paralleler Aufbau

# FIG 2C

Zylindrischer Aufbau